# FASCICULE DE BREVET EUROPEEN

(11) **EP 0 860 948 B1**
(45) Date de publication et mention de la délivrance du brevet: **18.08.2004**
(21) Numéro de dépôt: 98410015.6
(22) Date de dépôt: 24.02.1998
(51) Int. Cl.: H03K 19/017, H03K 19/0185

(54) **Amplicateur-tampon de commande de bus**
Pufferverstärker für Bussteuerung
Buffer amplifier for controlling bus

(30) Priorité: 25.02.1997 FR 9702459
(43) Date de publication de la demande: 26.08.1998
(73) Titulaire: STMicroelectronics S.A., 92120 Montrouge (FR)
(72) Inventeur: Bouras, Ilias, 16342 Ilioupolis, Athenes (GR); Papadas, Constantin, 38610 Gieres (FR); Moreau, Jean-Pierre, 38610 Gieres (FR)
(74) Mandataire: de Beaumont, Michel

(56) Documents cités:
- EP-A- 0 003 963
- EP-A- 0 533 339
- US-A- 4 042 839
- US-A- 4 714 840
- US-A- 5 382 846
- US-A- 5 422 591

## Description

La présente invention concerne le domaine des circuits intégrés et plus particulièrement la réalisation d'amplificateurs-tampon dans des circuits intégrés de type MOS.

De façon générale, dans un circuit intégré, il faut commander à partir de signaux logiques l'état de divers composants élémentaires reliés à une ligne commune ou bus. Pour cela, on recourt à des amplificateurs-tampon ayant pour rôle d'adapter l'impédance du signal logique au bus à commander. On s'intéressera plus particulièrement ici au cas où l'on cherche à réaliser cette commande de façon très rapide et où le nombre de dispositifs à commander connectés au bus peut être important, c'est-à-dire que ces dispositifs présentent dans leur ensemble une charge capacitive importante.

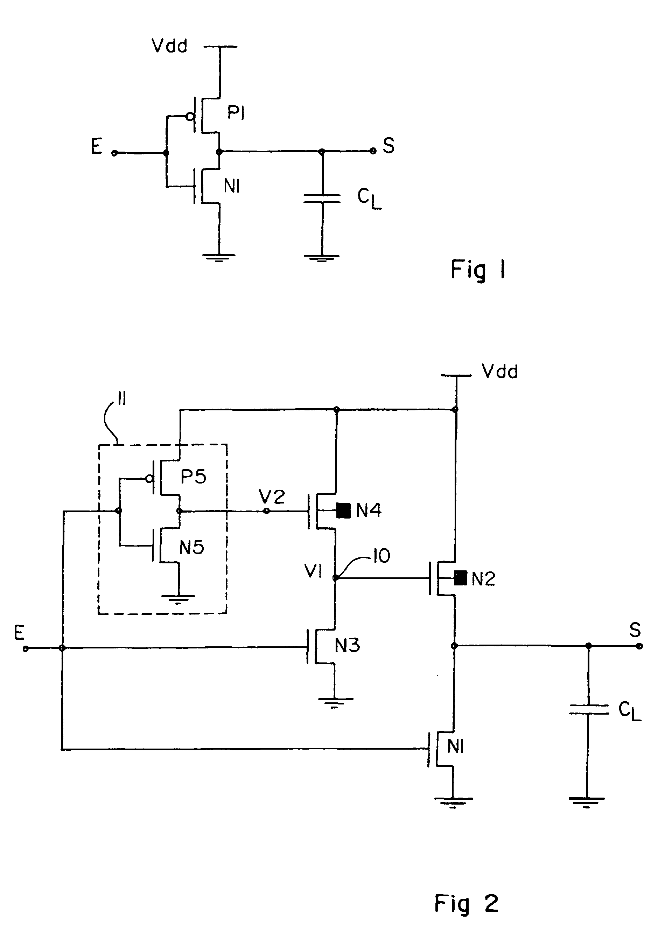

La figure 1 représente le type le plus courant d'amplificateur-tampon utilisé en technologie MOS. Cet amplificateur-tampon est constitué d'un simple inverseur comprenant deux transistors MOS complémentaires, respectivement à canal P et à canal N, P1 et N1, connectés en série entre une ligne d'alimentation haute Vdd et la masse. Les grilles des transistors P1 et N1 sont reliées ensemble à une borne d'entrée E, et le drain commun des transistors P1 et N1 est connecté à une borne de sortie S. On a également représenté sur la figure sous forme d'un condensateur C_{L} la charge équivalente de la ligne ou bus relié à la borne S.

Quand le signal d'entrée est à niveau bas, la tension sur la borne de sortie S est à niveau haut, et inversement. Cet amplificateur-tampon élémentaire présente, comme cela est bien connu, l'inconvénient d'être mal adapté à un fonctionnement à haute fréquence. Ceci est essentiellement lié à la présence d'un transistor MOS à canal P qui est intrinsèquement plus lent qu'un transistor MOS à canal N. Ainsi, les transitions de la sortie du niveau bas au niveau haut ont nécessairement une vitesse réduite. Ceci est d'autant plus gênant que la charge connectée à la borne de sortie est fortement capacitive.

Pour remédier à cet inconvénient, on est amené à utiliser des transistors MOS à canal P de plus grande dimension afin de fournir un courant de commande de plus grande amplitude sur la ligne de sortie. Cette solution s'oppose bien entendu à l'objectif général de réduction des dimensions des dispositifs semiconducteurs et des circuits intégrés qui les contiennent.

Une deuxième solution consiste à fractionner la ligne connectée à la borne S et à utiliser un amplificateur-tampon pour chaque fraction de ligne. Cette solution entraîne bien évidemment une augmentation de la dimension globale du circuit.

Ainsi, les deux solutions proposées dans l'art antérieur conduisent à une augmentation de dimension du circuit intégré, ce qui constitue en soi un inconvénient auquel s'ajoute le fait que la capacité d'entrée de l'amplificateur-tampon augmente avec les dimensions ou le nombre des transistors qu'il contient. En conséquence, les circuits amont destinés à fournir le signal d'entrée E doivent eux-mêmes présenter des performances adaptées.

Bien entendu, on a aussi essayé dans l'art antérieur de réaliser divers circuits plus complexes remplaçant le circuit élémentaire de la figure 1, mais les inconvénients fondamentaux exposés ci-dessus (grande dimension, vitesse de commutation vers l'état haut limitée, et forte capacité d'entrée) ne sont pas fondamentalement résolus.

En conséquence, dans l'art antérieur, quand on cherche à commander à vitesse élevée un bus susceptible d'être fortement capacitif, on utilise des circuits intégrés de type bipolaire ou des circuits intégrés en technologie mixte bipolaire et MOS.

Un objet de la présente invention est de prévoir un amplificateur-tampon à vitesse de commutation élevée réalisé en technologie MOS.

Un autre objet de la présente invention est de prévoir un amplificateur-tampon à faible capacité d'entrée.

Un autre objet de la présente invention est de prévoir un amplificateur-tampon capable de commander une ligne susceptible d'être capacitive.

Un autre objet de la présente invention est de prévoir un circuit amplificateur-tampon de surface optimale.

Ces objets ainsi que d'autres sont atteints par un amplificateur-tampon de commande de bus, comprenant une borne d'entrée et une borne de sortie reliée à la ligne de sortie, la borne de sortie étant associée à un premier transistor MOS à canal N de mise à niveau bas et à un deuxième transistor MOS à canal N de mise à niveau haut, le premier transistor MOS à canal N étant commandé directement par un signal d'entrée. Dans cet amplificateur-tampon, le deuxième transistor MOS est à canal N, et sa grille est commandée par un troisième transistor MOS à canal N de mise à niveau bas directement commandé par le signal d'entrée, et par un quatrième transistor MOS à canal N de mise à niveau haut, qui est commandé par le signal d'entrée inversé ; et le quatrième transistor MOS à canal N comprend une jonction drain-substrat très abrupte.

Selon un mode de réalisation de la présente invention, le substrat du quatrième transistor MOS à canal N est flottant.

Selon un mode de réalisation de la présente invention, l'amplificateur-tampon est réalisé en technologie submicronique.

Selon un mode de réalisation de la présente invention, le substrat du deuxième transistor MOS à canal N est flottant.

Selon un mode de réalisation de la présente invention, le deuxième transistor MOS à canal N a les mêmes dimensions que le premier transistor MOS à canal N.

Selon un mode de réalisation de la présente invention, le quatrième transistor est défini de telle sorte que la surface du quatrième transistor est trois fois plus petite que celle du deuxième transistor.

Selon un mode de réalisation de la présente invention, le quatrième transistor est défini de telle sorte que la longueur de canal du quatrième transistor est égale à six fois celle du troisième transistor.

Ces objets, caractéristiques et avantages, ainsi que d'autres de la présente invention seront exposés en détail dans la description suivante d'un mode de réalisation particulier faite à titre non-limitatif en relation avec les figures jointes parmi lesquelles :
la figure 1 représente un exemple d'amplificateur-tampon classique ;
la figure 2 représente un amplificateur-tampon selon la présente invention ;
la figure 3 est une vue en coupe d'un transistor MOS à canal N utilisé dans le circuit de la figure 2 ;
la figure 4 illustre l'évolution dans le temps de tensions caractéristiques du circuit de la figure 2 ;
la figure 5 illustre la relation entre le temps de montée du signal de sortie et le temps de montée du signal d'entrée pour le circuit de la figure 2 ; et
la figure 6 illustre la relation entre le temps de montée du signal de sortie et la charge capacitive de sortie pour un circuit classique et pour le circuit de la figure 2.

La figure 2 représente un amplificateur-tampon selon la présente invention. Cet amplificateur-tampon est connecté entre une borne d'entrée E et une borne de sortie S reliée à une charge de capacité C_{L}. La borne de sortie S est connectée au drain d'un transistor MOS à canal N N1 et à la source d'un transistor MOS à canal N N2. La source du transistor N1 est connectée à la masse, et le drain du transistor N2 est connecté à une source d'alimentation Vdd. De même, des transistors MOS à canal N N3 et N4 sont connectés en série entre la masse et la tension d'alimentation haute Vdd. Le point de raccordement 10 des transistors N3 et N4 est relié à la grille du transistor N2.

Les grilles des transistors N1 et N3 sont directement connectées à la borne d'entrée E. La grille du transistor N4 est connectée à la borne d'entrée E par l'intermédiaire d'un inverseur 11. L'inverseur 11 comprend par exemple, de façon classique, un transistor MOS à canal P P5 et un transistor MOS à canal N N5 en série entre la source d'alimentation Vdd et la masse.

Quand un signal d'entrée de niveau haut est appliqué sur la borne d'entrée E, les transistors N1 et N3 sont passants, et le transistor N4 est bloqué. Par conséquent, le transistor N2 est bloqué. Par suite, la borne de sortie S est reliée à la masse par le transistor N1 par lequel se décharge le condensateur C_{L}.

Quand le signal d'entrée sur la borne E est commuté à niveau bas, les transistors N1 et N3 se bloquent et le transistor N4 devient passant, ce qui rend passant le transistor N2 et tend à mettre la borne de sortie S à niveau haut, c'est-à-dire que l'on commence à charger le condensateur C_{L}.

Ce circuit présente a priori l'inconvénient que le niveau haut sur la borne S est limité. En effet, la tension V1 sur la grille du transistor N2 est normalement égale à Vdd moins la tension de seuil du transistor N4. On obtient donc sur la borne S une tension maximale égale à la tension sur la grille du transistor N2 moins la tension de seuil de ce transistor N2, c'est-à-dire une tension sensiblement égale à Vdd-V_{TH4}-V_{TH2} où V_{TH4} et V_{TH2} désignent les tensions de seuil des transistors N4 et N2.

Ainsi, le circuit selon la présente invention semble présenter un inconvénient plutôt qu'un avantage par rapport au circuit de l'art antérieur du fait que la tension de sortie haute est limitée, inconvénient qui est particulièrement grave quand les tensions d'alimentation sont faibles et c'est aujourd'hui la tendance des circuits intégrés d'utiliser des tensions d'alimentation haute de plus en plus faibles, par exemple de l'ordre de 3 V.

Pour résoudre ce problème, la présente invention prévoit non seulement d'utiliser le circuit décrit précédemment mais encore de réaliser ce circuit et notamment le transistor N4 dans une technologie particulière.

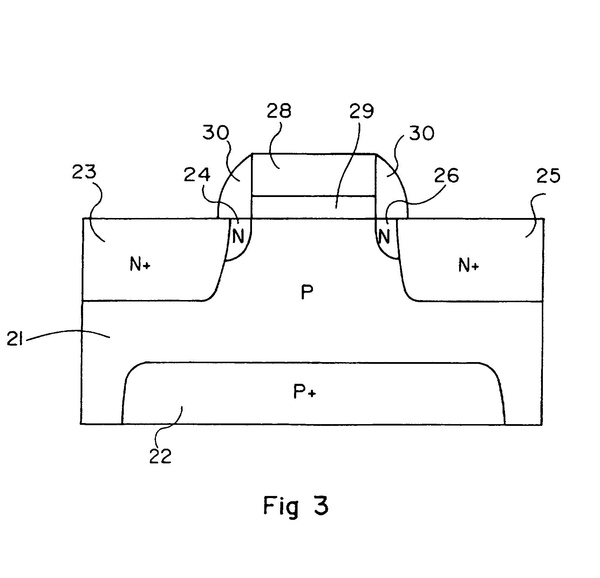

La figure 3 représente de façon schématique une vue en coupe d'un transistor MOS classique formé dans un substrat semiconducteur 21 de type P au-dessus d'une couche enterrée 22 de type N⁺. Ce transistor comprend une région de source 23 fortement dopée de type N et une région d'extension de source 24 de même qu'une région de drain 25 fortement dopée de type N et une région d'extension de drain 26. Une grille 28 est formée au-dessus d'une couche d'isolement de grille 29 et est encadrée d'espaceurs 30.

La présente invention utilise pour les transistors du circuit, et notamment pour le transistor N4 des transistors MOS réalisés en technologie submicronique (dans lesquels la longueur des grilles est inférieure à 0, 5 µm). Une caractéristique spécifique d'une telle technologie est que les zones de drain et de source sont fortement dopées et peu profondes, c'est-à-dire que la jonction entre le drain ou la source et le substrat est très abrupte.

Ceci entraîne, en ce qui concerne le fonctionnement du circuit de la figure 2, que, quand une impulsion de grille est appliquée au transistor N4, ce transistor devient passant et les capacités présentes au noeud 10 (capacité de source du transistor N4, capacité de drain du transistor N3, capacité de grille du transistor N2) se chargent à un potentiel Vdd-V_{TH4}. Alors, le transistor N4 se rebloque et les charges sur le noeud 10 ne peuvent plus se décharger puisque le transistor N3 a été bloqué par l'impulsion qui a rendu le transistor N4 passant. Une zone de déplétion (isolante), d'autant plus importante que les jonctions sont abruptes, se forme sous la source du transistor N4 et sous le drain du transistor N3. Il en résulte une diminution des valeurs des capacités de source du transistor N4 et de drain du transistor N3 et donc de la capacité globale du noeud 10. Les charges se conservant, la tension sur le noeud 10 tend à croître et atteint une valeur supérieure à la tension Vdd. Le transistor N2 est donc commandé de façon optimale et le niveau haut sur la borne S est au moins égal à celui que l'on obtient avec le circuit inverseur de la figure 1.

Selon les inventeurs, ce phénomène est plus marqué si le transistor N4 est à substrat flottant.

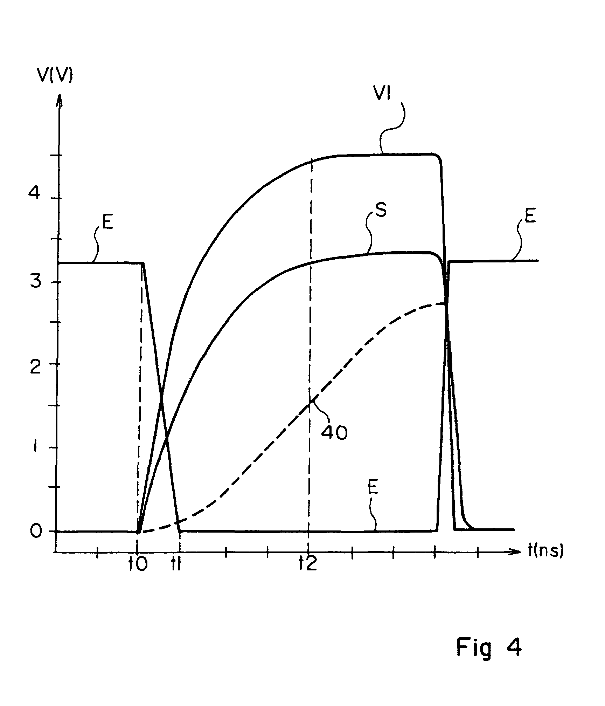

Quelle que soit l'explication théorique, on observe le résultat illustré en figure 4. Dans cette figure, on a illustré les variations en fonction du temps de la tension sur la borne E, de la tension sur la borne S et de la tension V1 sur le noeud 10. On part d'un état dans lequel la tension sur la borne d'entrée E est haute et la tension sur la borne de sortie S est basse. On suppose qu'entre des instants t0 et t1, la tension sur la borne d'entrée E commute de niveau haut à niveau bas. Alors, la tension V1 sur le noeud 10 commence à croître et, comme on l'a indiqué précédemment, croît jusqu'à un niveau supérieur à la tension d'alimentation. En conséquence, la tension sur la borne de sortie S peut atteindre un niveau très proche de la tension Vdd.

Par ailleurs, on notera qu'en l'absence du phénomène décrit précédemment, la tension de sortie V1 aurait suivi l'allure illustrée par la courbe 40.

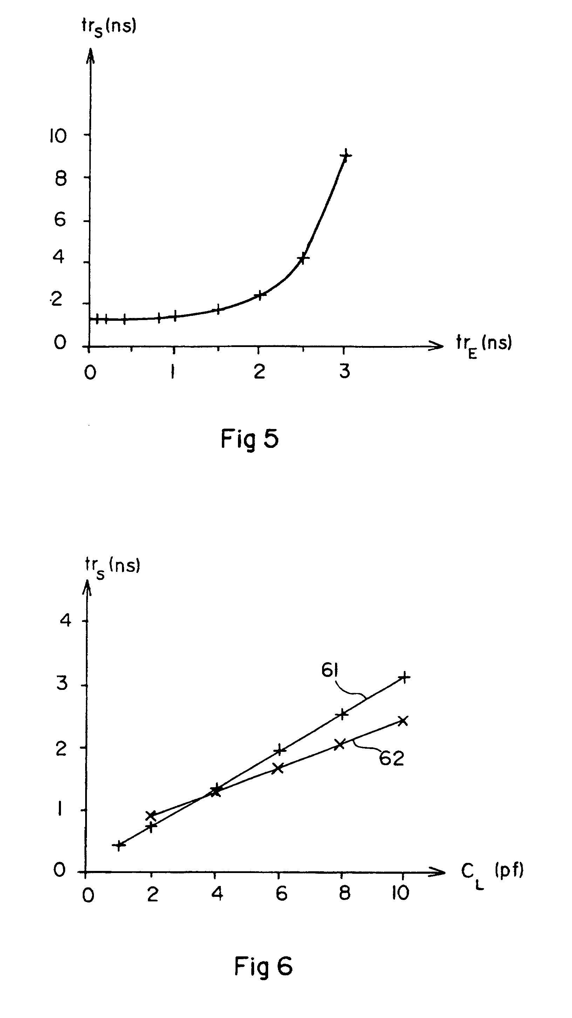

La figure 5 illustre la relation entre le temps de montée du signal de sortie (tr_{S}) et le temps de montée du signal d'entrée (tr_{E}) pour le circuit amplificateur-tampon selon la présente invention. Le temps de montée du signal de sortie croît lentement pour de faibles temps de montée du signal d'entrée (inférieurs à 2 ns), puis augmente brutalement. Ceci montre que l'effet de surtension sur le noeud 10 se produit bien pour des signaux d'entrée à croissance très rapide.

La figure 6 illustre la relation entre le temps de montée du signal de sortie (tr_{S}) et la charge capacitive pour le circuit selon la présente invention (courbe 61) et pour un circuit classique (courbe 62). Dans les deux cas, le temps de montée du signal de sortie varie linéairement avec la capacité C_{L}. Toutefois, la pente est plus faible dans le cas du circuit selon la présente invention. On voit que pour des capacités élevées (d'environ 10 pF par exemple) la valeur du temps de montée est réduite d'environ 15 %. Ceci montre que le dispositif selon l'invention fournit une amélioration significative de la vitesse de commutation pour une ligne à forte charge capacitive.

Les inventeurs ont également observé que la consommation de puissance d'un circuit selon la présente invention n'était pas différente de celle d'un circuit classique.

Conformément aux objets recherchés, la présente invention fournit un circuit à faible capacité d'entrée car, contrairement au circuit classique, le transistor à canal P n'intervient pas directement pour charger le condensateur C_{L}, et donc n'a plus besoin d'être de grande taille. En pratique, un circuit selon la présente invention aura une capacité d'entrée réduite d'environ 50 % par rapport à celle du circuit classique.

La présente invention fournit aussi un circuit de surface minimale car, même si le nombre de composants du circuit de la présente invention est élevé par rapport celui d'un circuit classique, ces composants peuvent être de petite taille.

Les avantages maximaux de la présente invention sont obtenus dans le cas où les transistors de sortie N1 et N2 sont des transistors MOS à canal N. On notera toutefois que, même quand ces transistors sont des transistors bipolaires NPN, l'invention conserve des avantages par rapport à l'état de la technique. En effet, même si les transistors NPN sont par essence des commutateurs rapides, l'invention apporte l'avantage de procurer un accroissement de l'excursion de tension de sortie. En effet, grâce à la surtension apportée par le transistor N4 sur la borne de commande (la base) du transistor N2, on évite que la tension haute disponible sur la borne de sortie S soit inférieure d'une chute de tension base-émetteur (Vbe) à la tension d'alimentation haute (Vdd).

## Revendications

1. Amplificateur-tampon de commande de bus, comprenant une borne d'entrée (E) et une borne de sortie (S) reliée à une ligne de sortie, la borne de sortie étant associée à un premier transistor (N1) de mise à niveau bas et à un deuxième transistor (N2) de mise à niveau haut, le premier transistor (N1) étant commandé directement par un signal d'entrée, dans lequel :
la borne de commande du deuxième transistor (N2) est commandée par un troisième transistor MOS à canal N (N3) de mise à niveau bas directement commandé par le signal d'entrée, et par un quatrième transistor MOS à canal N (N4) de mise à niveau haut, qui est commandé par le signal d'entrée inversé ; et
**caractérisé en ce que** le quatrième transistor MOS à canal N (N4) comprend une jonction drain-substrat très abrupte.

2. Amplificateur-tampon selon la revendication 1, **caractérisé en ce que** les premier (N1) et deuxième (N2) transistors sont des transistors MOS à canal N.

3. Amplificateur-tampon selon la revendication 1, **caractérisé en ce que** le substrat du quatrième transistor MOS à canal N (N4) est flottant.

4. Amplificateur-tampon selon la revendication 1, **caractérisé en ce qu'**il est réalisé en technologie submicronique.

5. Amplificateur-tampon selon la revendication 2, **caractérisé en ce que** le substrat du deuxième transistor MOS à canal N est flottant.

6. Amplificateur-tampon selon la revendication 2, **caractérisé en ce que** le deuxième transistor MOS à canal N a les mêmes dimensions que le premier transistor MOS à canal N.

7. Amplificateur-tampon selon la revendication 2, **caractérisé en ce que** le quatrième transistor est défini de telle sorte que la surface du quatrième transistor est trois fois plus petite que celle du deuxième transistor.

8. Amplificateur-tampon selon la revendication 2, **caractérisé en ce que** le quatrième transistor est défini de telle sorte que la longueur de canal du quatrième transistor est égale à six fois celle du troisième transistor.

## Claims

1. A bus control buffer amplifier, having an input terminal (E) and an output terminal (S) connected to the output line, the output terminal being associated with a first pull transistor (N1) and a second pull-up transistor (N2), the first transistor being directly controlled by an input signal, wherein:
the second transistor (N2), has its gate controlled by a third pull-down N-channel MOS transistor (N3) directly controlled by the input signal, and by a fourth pull-up N-channel MOS transistor (N4), which is controlled by the inverted input signal; and
**characterized in that** the fourth N-channel MOS transistor (N4) includes a very abrupt drain-substrate junction.

2. The buffer amplifier of claim 1, **characterized in that** the first (N1) and second (N2) transistors are N-channel MOS transistors.

3. The buffer amplifier of claim 1, **characterized in that** the substrate of the fourth N-channel MOS transistor (N4) is a floating substrate.

4. The buffer amplifier of claim 1, **characterized in that** it is implemented in submicronic technology.

5. The buffer amplifier of claim 2, **characterized in that** the substrate of the second N-channel MOS transistor is a floating substrate.

6. The buffer amplifier of claim 2, **characterized in that** the second N-channel MOS transistor has the same dimensions as the first N-channel MOS transistor.

7. The buffer amplifier of claim 2, **characterized in that** the fourth transistor is defined so that the surface area of the fourth transistor is three times smaller than that of the second transistor.

8. The buffer amplifier of claim 2, **characterized in that** the fourth transistor is defined so that the channel length of the fourth transistor is equal to six times that of the third transistor.

## Patentansprüche

1. Ein Bussteuerpufferverstärker mit einem Eingangsanschluss (E) und einem Ausgangsanschluss (S), verbunden mit der Ausgangsleitung, wobei der Ausgangsanschluss mit einem ersten "Pull"-Transistor (N1) und einem zweiten "Pull-up"-Transistor (N2) verbunden ist, wobei der erste Transistor direkt durch ein Eingangssignal geregelt wird, wobei Folgendes vorgesehen ist:
das Gate des zweiten Transistors (N2) wird durch einen dritten direkt durch das Eingangssignal gesteuerten "Pull-down" N-Kanal-MOS-Transistor (N3) und durch einen vierten "Pull-up" N-Kanal-MOS-Transsitor (N4), der durch das invertierte Eingangssignal gesteuert wird; und
ferner **dadurch gekennzeichnet, dass** der vierte N-Kanal-MOS-Transistor (N4) eine sehr abrupte Drain-Substrat-Grenzschicht (junction) aufweist.

2. Der Pufferverstärker nach Anspruch 1, **dadurch gekennzeichnet, dass** die ersten (N1) und zweiten (N2) Transistoren N-Kanal-MOS-Transistoren sind.

3. Der Pufferverstärker nach Anspruch 1, **dadurch gekennzeichnet, dass** das Substrat des vierten N-Kanal-MOS-Transistors (N4) ein schwimmendes Substrat ist.

4. Der Pufferverstärker nach Anspruch 1, **dadurch gekennzeichnet, dass** die Implementierung in Submikrontechnologie erfolgt.

5. Der Pufferverstärker nach Anspruch 2, **dadurch gekennzeichnet, dass** das Substrat des zweiten N-Kanal-MOS-Transistors ein schwimmendes Substrat ist.

6. Der Pufferverstärker nach Anspruch 2, **dadurch gekennzeichnet, dass** der zweite N-Kanal-MOS-Transistor die gleichen Dimensionen besitzt wie der erste N-Kanal-MOS-Transistor.

7. Der Pufferverstärker nach Anspruch 2, **dadurch gekennzeichnet, dass** der vierte Transistor derart definiert ist, dass das Oberflächengebiet oder die Oberfläche des vierten Transistors dreimal kleiner ist als die des zweiten Transistors.

8. Der Pufferverstärker nach Anspruch 2, **dadurch gekennzeichnet, dass** der vierte Transistor derart definiert ist, dass die Kanallänge des vierten Transistors gleich dem sechsfachen des dritten Transistors ist.
